# EUROPEAN PATENT APPLICATION

(11) **EP 1 077 482 A2**
(43) Date of publication of application: **21.02.2001**
(21) Application number: 00307040.6
(22) Date of filing: 16.08.2000
(51) Int. Cl.: H01L 21/48, H01L 23/498

(54) **Semiconductor contacting device**

(30) Priority: 19.08.1999 JP 23273799
(71) Applicant: SHINKO ELECTRIC INDUSTRIES CO. LTD., Nagano-shi, Nagano 380-0921 (JP)
(72) Inventor: Higashi, Mitsutoshi, Shinko Electric Ind. Co. Ltd., Nagano-shi, Nagano 380-0921 (JP); Sakaguchi, Hideaki, Shinko Electric Ind. Co. Ltd., Nagano-shi, Nagano 380-0921 (JP); Murayama, Kei, c/o Shinko Electric Ind. Co. Ltd., Nagano-shi, Nagano 380-0921 (JP); Koike, Hiroko, c/o Shinko Electric Ind. Co. Ltd., Nagano-shi, Nagano 380-0921 (JP)
(74) Representative: Rackham, Stephen Neil

(57) **Abstract**

A process of producing a semiconductor device including a semiconductor chip (10), electrode terminals (12) formed on an electrode terminal carrying surface of the semiconductor chip (10), conductor wires (14) bonded to, and standing on, the electrode terminals (12), and solder bumps (38) formed on respective tips of the conductor wires (14), comprises the steps of: forming spots of a solder paste (32) corresponding in arrangement to the tips of the wires (14), on a substrate (30) less wettable by the solder than the wires (14); positioning the spots of the solder paste (32) with the tips of the wires (14); and, heating the spots of the solder paste (32) to form solder bumps (38) on the tips of the wires (14).

## Description

The present invention relates to a process of producing a semiconductor device including a semiconductor chip, electrode terminals formed on an electrode terminal carrying surface of the semiconductor chip, external connection terminals or conductor wires bonded to, and standing on, the electrode terminals, and solder bumps formed on respective tips of the conductor wires. The present invention also relates to a semiconductor device produced by the process.

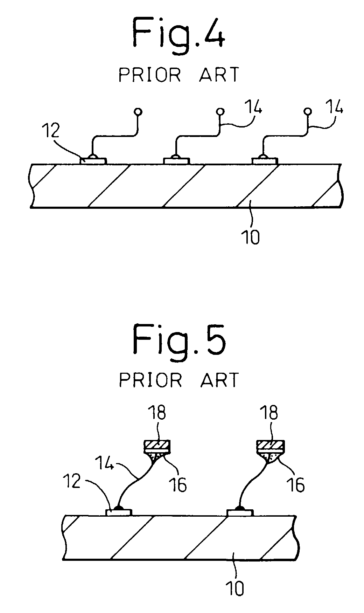

Figure 4 shows a conventional semiconductor device including a semiconductor chip 10, electrode terminals 12 formed on an electrode terminal carrying surface of the chip 10, external connection terminals or L-shaped bent wires 14 bonded to, and standing on, the electrode terminals 12. The wires 14 are provided with a spring function by being bent in an L-shape to mitigate thermal or other stresses generated between a semiconductor chip and a motherboard upon mounting the former on the latter. The external connection terminals 14 are formed by bonding a gold wire to the electrode terminals 12, bending the bonded wire in an L-shape, and cutting the wires on the free end. The external connection terminals 14 are formed by bonding the wire either to the electrode terminals 12 or to lands or terminals of extension wiring patterns formed on the electrode terminal carrying surface of the semiconductor chip 10. The extension terminals 14 may be reinforced by plating to keep the designed shape. After the external connection terminals 14 are formed, the electrode carrying surface may be coated with a resin or the like to cover the extension wiring patterns. The term "electrode terminal" used herein also means a "land" formed in the extension wiring pattern.

The semiconductor device shown in Fig. 14 is mounted on a motherboard by positioning and solder-bonding pads of the motherboard with the extension terminals 14. The positioning requires that a mounter precisely detects the positions of the tips of the external connection terminals 14. However, there is a problem in that the wire of the external connection terminals 14 has a diameter as small as about 50 µm and cannot be precisely detected by a usual mounter having a detectability of about 200 µm, so that precise mounting cannot be carried out.

A solution to the problem is to provide a mounting terminal on the tips of the external connection terminals 14 before mounting, as shown in Fig. 5. The mounting terminals 18 are bonded to the tips of the external connection terminals 14 with a solder 16.

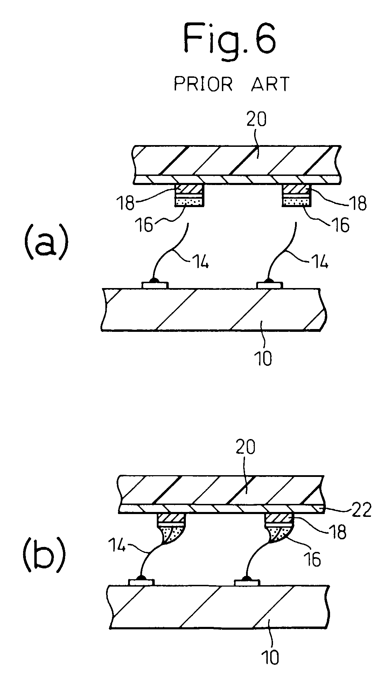

As shown in Fig. 6, step (a) positions a substrate 20 having mounting terminals 18 formed thereon corresponding in arrangement to the external connection terminals 14 with a semiconductor chip 10 having external connection terminals 14 bonded thereto and standing thereon, and step (b) brings the tips of the external connection terminals 14 into contact with the mounting terminals 18 and heats and melts the solder 16 on the mounting terminals 18 to bond the external connection terminals 14 to the mounting terminals 18. Thereafter, chemical etching is carried out to dissolve a metal layer 22 to remove the mounting terminals 18 from the substrate 20, thereby completing the semiconductor device as shown in Fig. 5. The metal layer 22 is formed of aluminum or other metals which can be easily dissolved and removed by chemical etching.

The semiconductor device shown in Fig. 5 has the external connection terminals 14, having the mounting terminals 18 on the tips thereof, to enable precise positioning and mounting of the device to be achieved by a usual mounter.

However, the above-mentioned process is complicated because it requires chemical etching to remove the mounting terminals 18 from the substrate 20, other than forming the mounting terminals 18 on the substrate 20 and bonding the mounting terminals 18 to the external connection terminals 14.

An object of the present invention is to provide a process of producing a semiconductor device having external connection terminals provided, on the tip, with a mounting terminal of a solder, in which the external connection terminals formed from a wire are easily positioned on a motherboard.

Another object of the present invention is to provide a semiconductor device produced by the process.

To achieve the object according to the present invention, there is provided a process of producing a semiconductor device including a semiconductor chip, electrode terminals formed on an electrode terminal carrying surface of the semiconductor chip, conductor wires bonded to, and standing on, the electrode terminals, and solder bumps formed on respective tips of the conductor wires, comprising the steps of:
forming spots of a solder paste corresponding in arrangement to the tips of the wires, on a substrate less wettable by the solder than the wires;
positioning the spots of the solder paste with the tips of the wires; and
heating the spots of the solder paste to form solder bumps on the tips of the wires.

The process according to the present invention is much simplified at least by not requiring the chemical etching required in the prior art.

In a first preferred embodiment, the step of forming the spots of the solder paste on the substrate comprises:
placing on the substrate a mask plate having throughholes corresponding in arrangement to the tips of the wires; and
filling the solder paste in the throughholes.

In a second preferred embodiment, the step of forming the spots of the solder paste on the substrate comprises:
bonding to the substrate a film having throughholes corresponding in arrangement to the tips of the wires; and
filling the solder paste in the throughholes.

In a third preferred embodiment, the step of forming the spots of the solder paste on the substrate comprises:
filling the solder paste in recesses of the substrate, the recesses corresponding in arrangement to the tips of the wires.

According to the present invention, there is also provide a semiconductor device including a semiconductor chip, electrode terminals formed on an electrode terminal carrying surface of the semiconductor chip, conductor wires bonded to, and standing on, the electrode terminals, and solder bumps formed on respective tips of the conductor wires, the semiconductor device being produced by a process comprising the steps of:
forming spots of a solder paste corresponding in arrangement to the tips of the wires, on a substrate less wettable by the solder than the wires;
positioning the spots of the solder paste with the tips of the wires;
heating the spots of the solder paste to form solder bumps on the tips of the wires.

The solder bumps are preferably globular.

### BRIEF DESCRIPTION OF THE DRAWINGS

Figure 1 shows process steps (a) - (e) according to the first embodiment of the present invention, in cross-sectional views;
Fig. 2 shows process steps (a) - (c) according to the second embodiment of the present invention, in cross-sectional views;
Fig. 3 shows process steps (a) - (c) according to the third embodiment of the present invention, in cross-sectional views;
Fig. 4 shows a conventional semiconductor device, in a cross-sectional view;
Fig. 5 shows a conventional semiconductor device having external connection terminals provided with mounting terminals on the tips thereof, in a cross-sectional view; and
Fig. 6 shows the conventional process steps (a) - (b) to form mounting terminals on the tips of the external connection terminals of the semiconductor device shown in Fig. 5.

The present invention will be described in further detail by way of the following examples, particularly the production of a semiconductor device having external connection terminals formed from a conductor wire bent in an L-shape to provide a spring function and the tips provided with globular solder bumps for mounting the device on a motherboard.

### Example 1

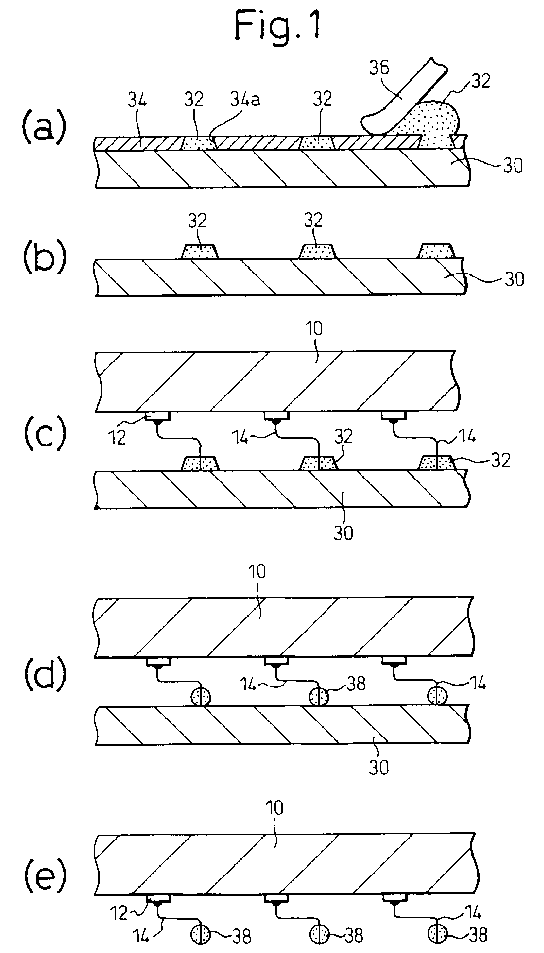

Figure 1 shows process steps (a) to (e) according to the first embodiment of the present invention.

Step (a) forms, on a substrate 30, spots 32 of a solder paste corresponding in arrangement to the tips of the external connection terminals 14, by printing using a mask plate 34 and a squeegee 36, the mask plate 34 having throughholes 34a corresponding in arrangement to the tips of the external connection terminals 14, in which a solder paste is filled in the throughholes 34a of the mask plate 34 and the excess portion thereof is removed by the squeegee 36. The mask plate 34, made of stainless steel or nickel, for example, typically has a thickness of about 150 µm and the throughholes 34a typically have a diameter of about 300 to 350 µm.

Step (b) removes the mask plate 34 to leave the solder paste spots 32 on the substrate 30 so that the spots 32 are arranged separately from each other and in positions corresponding to those of the tips of the external connection terminals 14. The substrate 30 is preferably a silicon wafer, which has a highly flat surface and is also less wettable by a solder (in the molten state) than a gold wire forming the external connection terminals 14. The gold wire is specifically composed of a core wire of gold plated with a Ni-Co alloy further plated with gold forming an outermost surface. The substrate 30 may be made of any one selected from the various materials less wettable with a solder than a wire forming the external connection terminals 14. Glass plates and ceramic plates may be used. The substrate 30 may be composed of a plate, made of Ni, for example, coated with another material less wettable with a solder than the wire forming the external connection terminals 14.

Step (c) positions the tips of the external connection terminals 14 of the semiconductor chip 10 onto the solder paste spots 32 on the substrate 30 and inserts the tips into the spots 32 until the tips contact the substrate 30.

Step (d) heats and melts the solder paste spots 32 to form solder bumps 38 on the tips of the external connection terminals 14. Because the substrate 30 is less wettable with the molten solder than the gold wire of the external connection terminals 14, the molten solder climbs up the external connection terminals 14 to form globes on the tips of the external connection terminals 14 by the surface tension of the molten solder.

Finally, after the globular solder balls 38 are solidified on the tips of the external connection terminals 14, step (e) removes the external connection terminals 14 having the solder balls 38 on the tips thereof from the substrate 30. The shown semiconductor device has the external connection terminals 14 provided with the solder balls 38 bonded to the tips thereof. The tips may occasionally protrude slightly from the solder balls 38.

The semiconductor device thus obtained is mounted on a motherboard by fusing the solder bumps 38 on the tips of the external connection terminals 14. During mounting, the solder bumps 38 have a diameter far greater than that of the wire of the external connection terminals 14 and are easily detected by a usual mounter to ensure precise positioning.

The semiconductor device of this embodiment is also advantageous because, during mounting on a motherboard, the external connection terminals 14 are self-aligned with pads of the motherboard by surface tension of a molten solder wetting both the external connection terminals and the pads.

According to this embodiment, the solder paste spots 32 formed by printing are advantageous because they are readily formed in different arrangements for different semiconductor devices by using mask plates having throughholes formed in different arrangements.

Printing is also advantageous because the solder paste spots 32 for plural semiconductor devices are collectively arranged on a single large substrate to provide an improved process efficiency.

It is also advantageous that positioning between the solder paste spots 32 and the tips of the external connection terminals 14 does not require a high precision but has an allowance within the diameter of the spots 32, because, during melting or reflowing of the solder, the molten solder is naturally attracted to the external connection terminals 14 to compensate for or cancel any positioning error within the allowance. Thus, the positioning can be successfully achieved by placing a semiconductor chip 10 on a positioning target marked on the substrate 30.

### Example 2

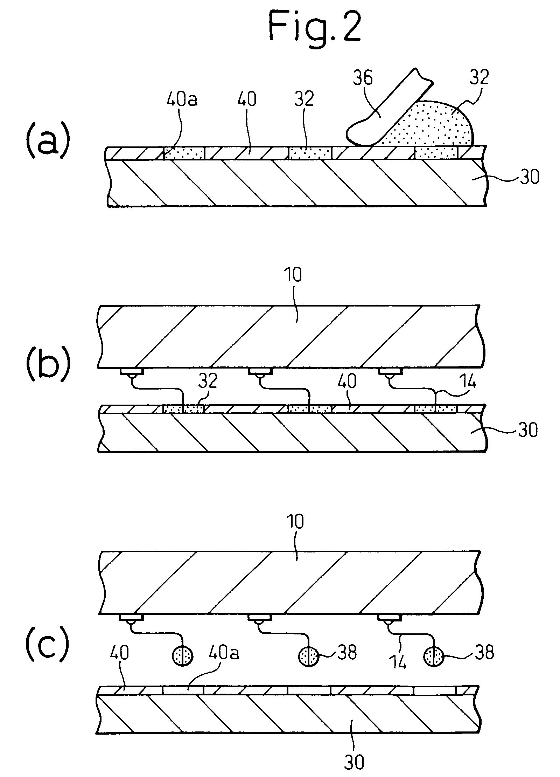

Figure 2 shows process steps (a) to (c) according to the second embodiment of the present invention. This embodiment replaces the mask plate 34 of Example 1 with a film 40 bonded to a substrate 30 and having throughholes 40a in which a solder paste 32 is filled. The throughholes 40a may be formed by punching the film 40, or by coating a polyimide or other photosensitive resin on the substrate 30 followed by exposing to light and development, or other suitable methods. The throughholes 40a are formed in an arrangement corresponding to that of the tips of the external connection terminals 14 of a semiconductor chip 10 and have a depth or length of about 150 µm and a diameter of about 300 µm. The substrate 30 on the other side may be also advantageously coated with the same film 40 having no throughholes to prevent distortion of the substrate 30 subjected to heat.

Step (a) forms, on a substrate 30, spots 32 of a solder paste by using a squeegee 36 to place the solder paste on the film 40 and fill in the throughholes 40a.

Step (b) positions the tips of the external connection terminals 14 of a semiconductor chip 10 with the solder paste spots 32 on the substrate 30 and inserts the tips into the spots 32 until the tips contact the substrate 30.

Step (c) heats and melts the solder paste spots 32 to form globular solder bumps 38 on the tips of the external connection terminals 14, which are then removed from the substrate 30.

Because the solder paste is thoroughly removed from the substrate 30 together with the external connection terminals 14, the substrate 30 having the film 40 bonded thereto can be readily reused for a next run of forming the solder paste spots 32. Substrates 30 provided with films 40 having throughholes 40a in different arrangements may be prepared for semiconductor chips 10 having different arrangements of the tips of the external connection terminals 14. Throughholes 40a are advantageously formed by application, exposure to light and development of a photosensitive resin to enable formation of very fine throughholes 40a.

### Example 3

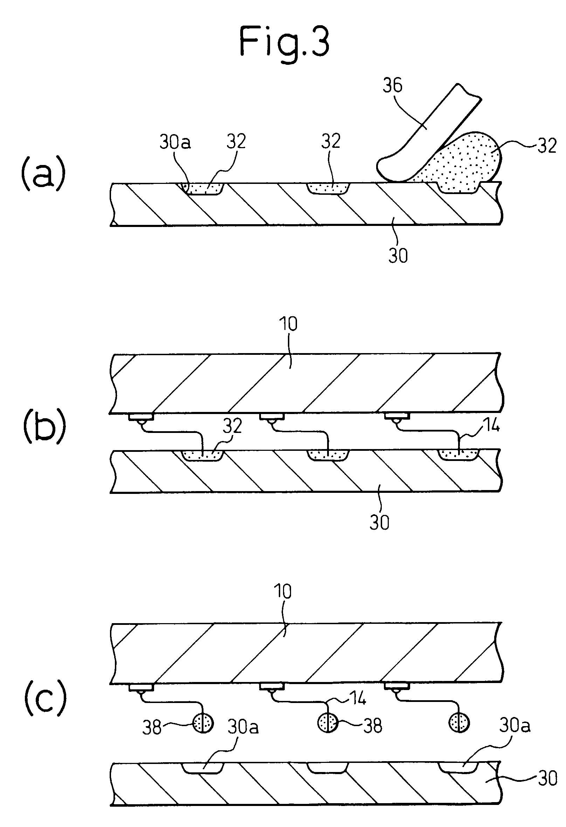

Figure 3 shows process steps (a) to (c) according to the third embodiment of the present invention. This embodiment uses a substrate 30 having recesses 30a in which a solder paste 32 is filled.

Step (a) forms, on a substrate 30 having the recesses 30a, spots 32 of a solder paste by using a squeegee 36 to place the solder paste on the substrate 30 and fill in the recesses 30a.

Step (b) positions the tips of the external connection terminals 14 of a semiconductor chip 10 with the solder paste spots 32 on the substrate 30 and inserts the tips into the spots 32 until the tips contact the substrate 30, i.e., the bottoms of the recesses 30a.

Step (c) heats and melts the solder paste spots 32 to form globular solder bumps 38 on the tips of the external connection terminals 14, which are then removed from the substrate 30.

Because the solder paste is thoroughly removed from the recesses 30a of the substrate 30 together with the external connection terminals 14, the substrate 30 having the recesses 30a can be readily reused for a next run of forming the solder paste spots 32. Substrates 30 provided with recesses 30a in different arrangements may be prepared for semiconductor chips 10 having different arrangements of the tips of the external connection terminals 14. The solder paste may be filled in the recesses 30a by potting instead of by using the squeegee 36.

Although Examples 1 to 3 describe forming solder bumps 38 in a single semiconductor chip 10, solder bumps 38 may be collectively formed in plural semiconductor chip precursors having respective electrode carrying surfaces even with each other and having external connection terminals 14 which precursors are formed in a semiconductor wafer, followed by cutting the wafer along the profile lines of the precursors to provide plural semiconductor devices having respective semiconductor chips corresponding to the precursors. Thus, the process according to the present invention is not only applicable to individual semiconductor chips but is also applicable to a wafer having semiconductor chip precursors formed therein, irrespective of the arrangement and number of the precursors in the wafer. Therefore, the herein used term "semiconductor chip" not only literally means an individual semiconductor chip but also inclusively means a semiconductor chip precursor on a wafer.

As herein described, the present invention provides a process of producing a semiconductor device having external connection terminals provided with globular solder bumps on the tips thereof, so that the tips of the external connection terminals can be easily positioned with pads of a motherboard during mounting of the semiconductor device on the motherboard by a usual mounter, in which the globular solder bumps are formed by a simplified process in comparison with the conventional process, particularly without using the chemical etching required in the conventional process. The present invention also provides a semiconductor device produced by the process.

## Claims

1. A process of producing a semiconductor device including a semiconductor chip (10), electrode terminal (12) formed on an electrode terminal carrying surface of the semiconductor chip (10), conductor wires (14) bonded to, and standing on, the electrode terminals (72), and solder bumps (38) formed on respective tips of the conductor wires (14), comprises the steps of:
forming spots of a solder paste (32) corresponding in arrangement to the tips of wires (14), on a substrate (30) less wettable by the solder than the wires (14); and,
positioning the spots of the solder paste (32) with the tips of the wires (14); and,
heating the spots of the solder paste (32) to form solder bumps (38) on the tips of the wires (14).

2. A process according to claim 1, wherein the step of forming the spots of the solder paste on the substrate comprises:
placing on the substrate a mask plate (34) having throughholes (34a) corresponding in arrangement to the tips of the wires (14); and,
filling the solder paste (32) in the throughholes (34a).

3. A process according to claim 1, wherein the step of forming the spots of the solder paste on the substrate comprises:
bonding to the substrate (30) a film (40) having throughholes (40a) corresponding in arrangement to the tips of the wires (14); and,
filling the solder paste (32) in the throughholes (40a).

4. A process according to claim 1, wherein the step of forming the spots of the solder paste on the substrate comprises:
filling the solder paste (32) in recesses (30a) of the substrate (30), the recesses (30a) corresponding in arrangement to the tips of the wires (14).

5. A process according to anyone of the preceding claims, further comprising the steps of:
preparing a semiconductor wafer having plural semiconductor chip precursors having respective electrode terminal carrying surfaces even with each other, the semiconductor chip precursors having conductor wires bonded thereto and standing thereon;
cutting the semiconductor wafer along profile lines of the semiconductor chip precursors to form plural semiconductor devices having respective semiconductor chips corresponding to the semiconductor chip precursors.

6. A semiconductor device including a semiconductor chip (10), electrode terminals (12) formed on an electrode terminal carrying surface of the semiconductor chip (10), conductor wires (14) bonded to, and standing on, the electrode terminals (12), and solder bumps (38) formed on respective tips of the conductor wires (14), the semiconductor device being produced by a process comprising the steps of:
forming spots of a solder paste (32) corresponding in arrangement to the tips of the wires (14), on a substrate (30) less wettable by the solder than the wires (14);
positioning the spots of the solder paste (32) with the tips (14) of the wires; and,
heating the spots of the solder paste (32) to form solder bumps (38) on the tips of the wires (14).

7. A semiconductor device according to claim 6, wherein the solder bumps (38) are globular.
